# EUROPEAN PATENT APPLICATION

(11) **EP 3 336 127 A1**
(43) Date of publication of application: **20.06.2018**
(21) Application number: 17205305.0
(22) Date of filing: 04.12.2017
(51) Int. Cl.: C08G 61/10, C08G 61/12, C09D 165/02, C08L 65/02, H01L 23/532

(54) **POLYARYLENE RESINS**

(30) Priority: 19.12.2016 US 201662436058 P
(71) Applicant: Rohm and Haas Electronic Materials LLC, Marlborough, MA 01752 (US)
(72) Inventor: WANG, Qing Min, Marlborough, MA Massachusetts 01752 (US); MICHAEL-SAPIA, Elizabeth K., Marlborough, MA Massachusetts 01752 (US); GILMORE, Christopher, Marlborough, MA Massachusetts 01752 (US); DING, Ping, Marlborough, MA Massachusetts 01752 (US); KIM, Young-Seok, Marlborough, MA Massachusetts 01752 (US)
(74) Representative: Houghton, Mark Phillip

(57) **Abstract**

Polyarylene polymers formed from an aromatic dialkyne monomer having a solubility enhancing moiety and having relatively high weight average molecular weights and a relatively low polydispersity show improved solubility in certain organic solvents and are useful in forming relatively thick dielectric material layers in a single coating step.

## Description

The present invention relates generally to the field of polyarylene materials and more particularly to polyarylene oligomers for use in electronics applications.

Polymer dielectrics may be used as insulating layers in various electronic devices, such as integrated circuits, multichip modules, laminated circuit boards, displays and the like. The electronics fabrication industry has different requirements for dielectric materials, such as dielectric constant, coefficient of thermal expansion, modulus, and the like, depending upon the particular application.

Various inorganic materials, such as silica, silicon nitride and alumina, have been used as dielectric materials in electronic devices. These inorganic materials generally can be deposited in thin layers, typically by vapor deposition techniques, and have advantageous properties, such as not readily absorbing water. Polymer dielectric materials often possess properties which offer advantages over inorganic dielectric materials in certain applications, such as ease of application such as by spin-coating techniques, gap-filling ability, lower dielectric constants, and the ability to withstand certain stresses without fracturing, that is, polymer dielectrics can be less brittle than inorganic dielectric materials. However, polymer dielectrics often present challenges to process integration during fabrication. For example, to replace silicon dioxide as a dielectric in certain applications such as integrated circuits, the polymer dielectric must be able to withstand processing temperatures during metallization and annealing steps of the process. In general, the polymer dielectric material should have a glass transition temperature greater than the processing temperature of subsequent manufacturing steps. Also, the polymer dielectric should not absorb water which may cause an increase in the dielectric constant and potential corrosion of metal conductors.

Polyarylene polymers are well-known as dielectric materials and possess many desirable properties. For example, International Pat. App. No. WO 97/10193 discloses certain polyarylene oligomers prepared from certain ethynyl-substituted aromatic compounds and a biscyclopentadienone monomer. The aromatic ring in these ethynyl-substituted aromatic compounds may be substituted with certain substituents such as CF₃-, CF₃O-, ArO-, ArS-, or (Ar)₂P(=O)-, wherein Ar designates a certain aromatic ring. Polyarylene oligomers are prepared at relatively high temperatures in organic solvents having relatively high boiling points (typically ≥ 150 °C). However, such reaction solvents are poor choices as casting solvents in the electronics industry, and the polyarylene oligomers must be precipitated from the reaction solvent and taken up in a different organic solvent with a much lower boiling point that is suitable for casting films of these polymers. Such polyarylene oligomers suffer from limited solubility in organic solvents conventionally used in the electronics industry, limiting the use of these polymers. U.S. Published Pat. App. No. 2016/0060393, discloses polar moiety-terminated polyarylene oligomers having improved solubility prepared by reacting a first monomer comprising two cyclopentadienone moieties, an ethynyl-substituted aromatic compound as a second monomer, and as a third monomer a monoethynyl-substituted compound of the formula R² 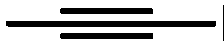 R³ wherein R² is H, optionally substituted C₁₋₁₀ alkyl, optionally substituted C₇₋₁₂ aralkyl, optionally substituted C₆₋₁₀ aryl, or R³, and R³ is a polar moiety. While these polar moiety-terminated polyarylene oligomers do have improved solubility in certain organic solvents as compared to conventional polyarylene oligomers, the solubility improvement in some solvents is not sufficient to allow these polyarylene oligomers to be used in certain applications in the electronics industry. There remains a need in the industry for polyarylene polymers having improved solubility in organic solvents, particularly in organic solvents used to cast polymer films in the electronics industry.

The present invention provides a polyarylene polymer comprising as polymerized units one or more first monomers comprising two or more cyclopentadienone moieties; and one or more polyalkynyl-substituted second monomers of formula (1): 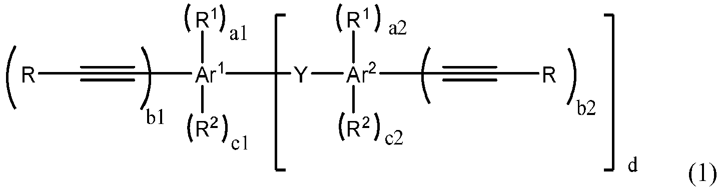 wherein each Ar¹ and Ar² is independently a C₅₋₃₀-aryl moiety; each R is independently chosen from H, and optionally substituted C₅₋₃₀-aryl; each R¹ is independently chosen from -OH, C₁₋₆-hydroxyalkyl, -C(=O)OR³, -C(=O)N(R⁴)₂, -O-C(=O)R,⁵-NR⁴C(=O)R⁶, -N(R⁴)₃⁺ An⁻, -NO₂; -S(=O)₂-OR⁷, -O-S(=O)₂-R⁸, -NR⁴-S(=O)₂-R⁶, and S(=O)₂-N(R⁴)₂; each R² is independently chosen from C₁₋₁₀-alkyl, C₁₋₁₀-haloalkyl, C₁₋₁₀-hydroxyalkyl, C₁₋₁₀-alkoxy, CN, N(R⁴)₂, and halo; R³ = H, C₁₋₁₀-alkyl, C₁₋₁₀-hydroxyalkyl, C₁₋₁₀-aminoalkyl, C₆₋₃₀-aryl, or M; each R⁴ is independently H, C₆₋₃₀-aryl, or C₁₋₁₀-alkyl; each R⁵ is independently chosen from H, C₁₋₁₀-alkyl, C₁₋₁₀-hydroxyalkyl, C₆₋₃₀-aryl, -O(C₁₋₁₀-alkyl), -O(C₆₋₁₀-aryl) and -N(R⁴)₂; R⁶ = H, C₁₋₁₀-alkyl, C₁₋₁₀-hydroxyalkyl, C₆₋₃₀-aryl, -O(C₁₋₁₀-alkyl), or -NH(C₁₋₁₀-alkyl); R⁷ = H, C₁₋₁₀-alkyl, C₆₋₃₀-aryl, or M; R⁸ = C₆₋₃₀-aryl, C₁₋₁₀-alkyl, or C₁₋₁₀-haloalkyl; M = an alkali metal ion, an alkaline earth metal ion, or an ammonium ion; An⁻ is an anion chosen from halide and C₁₋₂₀-carboxylate; each Y is independently a single covalent chemical bond or a divalent linking group chosen from -O-, -S-, -S(=O)-, -S(=O)₂-, -C(=O)-,-(C(R⁹)₂)_{z}-, C₆₋₃₀-aryl, and -(C(R⁹)₂)_{z1}-(C₆₋₃₀-aryl)-(C(R⁹)₂)_{z2}-; each R⁹ is independently chosen from H, hydroxy, halo, C₁₋₁₀-alkyl, C₁₋₁₀-haloalkyl, and C₆₋₃₀-aryl; a1 = 0 to 3; a2 = 0 to 3; b1 = 1 to 4; b2 = 0 to 2; c1 = 0 to 4; c2 = 0 to 4; a1 + a2 = 1 to 6; b1 + b2 = 2 to 6; c1 + c2 = 0 to 6; d = 0 to 2; z = 1 to 10; z1 = 0 to 10; z2 = 0 to 10; and z1 + z2 = 1 to 10; wherein the polyarylene polymer has a Mₙ of 10,000 to 50,000 Da, a M_{w} of 30,000 to 150,000 Da, and a PDI of 1 to <6.

Also provided by the present invention is a composition comprising one or more polyarylene polymers described above and one or more organic solvents.

Further, the present invention provides a method of forming a dielectric material layer comprising: disposing a layer of the composition described above on a substrate surface; removing the organic solvent; and curing the polymer to form a dielectric material layer.

The present invention also provides a method of preparing a polyarylene polymer comprising: (a) reacting a molar amount of a first monomer comprising two or more cyclopentadienone moieties with a first portion of a molar amount of a polyalkynyl-substituted second monomer formula (1): 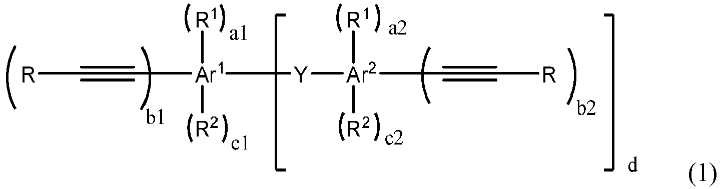 wherein each Ar¹ and Ar² is independently a C₅₋₃₀-aryl moiety; each R is independently chosen from H, and optionally substituted C₅₋₃₀-aryl; each R¹ is independently chosen from -OH, C₁₋₆-hydroxyalkyl, -C(=O)OR³, -C(=O)N(R⁴)₂, -O-C(=O)R,⁵-NR⁴C(=O)R⁶, -N(R⁴)₃⁺ An⁻, -NO₂; -S(=O)₂-OR⁷, -O-S(=O)₂-R⁸, -NR⁴-S(=O)₂-R⁶, and S(=O)₂-N(R⁴)₂; each R² is independently chosen from C₁₋₁₀-alkyl, C₁₋₁₀-haloalkyl, C₁₋₁₀-hydroxyalkyl, C₁₋₁₀-alkoxy, CN, N(R⁴)₂, and halo; R³ = H, C₁₋₁₀-alkyl, C₁₋₁₀-hydroxyalkyl, C₁₋₁₀-aminoalkyl, C₆₋₃₀-aryl, or M; each R⁴ is independently H, C₆₋₃₀-aryl, or C₁₋₁₀-alkyl; each R⁵ is independently chosen from H, C₁₋₁₀-alkyl, C₁₋₁₀-hydroxyalkyl, C₆₋₃₀-aryl, -O(C₁₋₁₀-alkyl), -O(C₆₋₁₀-aryl) and -N(R⁴)₂; R⁶ = H, C₁₋₁₀-alkyl, C₁₋₁₀-hydroxyalkyl, C₆₋₃₀-aryl, -O(C₁₋₁₀-alkyl), or -NH(C₁₋₁₀-alkyl); R⁷ = H, C₁₋₁₀-alkyl, C₆₋₃₀-aryl, or M; R⁸ = C₆₋₃₀-aryl, C₁₋₁₀-alkyl, or C₁₋₁₀-haloalkyl; M = an alkali metal ion, an alkaline earth metal ion, or an ammonium ion; An⁻ is an anion chosen from halide and C₁₋₂₀-carboxylate; each Y is independently a single covalent chemical bond or a divalent linking group chosen from -O-, -S-, -S(=O)-, -S(=O)₂-, -C(=O)-,-(C(R⁹)₂)_{z}-, C₆₋₃₀-aryl, and -(C(R⁹)₂)_{z1}-(C₆₋₃₀-aryl)-(C(R⁹)₂)_{z2}-; each R⁹ is independently chosen from H, hydroxy, halo, C₁₋₁₀-alkyl, C₁₋₁₀-haloalkyl, and C₆₋₃₀-aryl; a1 = 0 to 3; a2 = 0 to 3; b1 = 1 to 4; b2 = 0 to 2; c1 = 0 to 4; c2 = 0 to 4; a1 + a2 = 1 to 6; b1 + b2 = 2 to 6; c1 + c2 = 0 to 6; d = 0 to 2; z = 1 to 10; z1 = 0 to 10; z2 = 0 to 10; and z1 + z2 = 1 to 10; then (b) reacting the molar amount of the first monomer with a second portion of the second monomer; and (c) optionally repeating step (b) with one or more additional portions of the second monomer; wherein the first portion of the second monomer is less than 1 equivalent based on the molar amount of the first monomer; wherein the sum of the first portion, the second portion and any optional addition portions of the second monomer is from 0.8 to 1.2 molar equivalents based on the molar amount of the first monomer; and wherein the polyarylene polymer has a Mₙ of 10,000 to 50,000 Da, a M_{w} of 30,000 to 150,000 Da, and a PDI of 1 to <6.

As used throughout this specification, the following abbreviations shall have the following meanings, unless the context clearly indicates otherwise: °C = degree Celsius; g = gram; mg = milligram; L = liter; mL = milliliter; Å = angstrom; nm = nanometer; µm = micron = micrometer; mm = millimeter; sec. = second; min. = minute; hr. = hour; DI = deionized; and Da = daltons. Unless otherwise specified, all amounts are percent by weight ("wt%") and all ratios are molar ratios. All numerical ranges are inclusive and combinable in any order, except where it is clear that such numerical ranges are constrained to add up to 100%. The articles "a", "an" and "the" refer to the singular and the plural. "Alkyl" refers to linear, branched and cyclic alkyl unless otherwise specified. "Alkyl" refers to an alkane radical, and includes alkane monoradicals, diradicals (alkylene), and higher-radicals. "Halo" refers to fluoro, chloro, bromo, and iodo. When an element is referred to as being "disposed on" another element, it can be directly on the other element or intervening elements may be present therebetween. In contrast, when an element is referred to as being "disposed directly on" another element, there are no intervening elements present.

As used herein, an "optionally substituted" moiety refers to both an unsubstituted moiety and a substituted moiety, such as "optionally substituted aryl" refers to both unsubstituted aryl and substituted aryl. "Aryl" refers to aromatic carbocycles and aromatic heterocycles. The term "aryl" refers to an aromatic radical, and includes monoradicals, diradicals (arylene), and higher-radicals. It is preferred that aryl moieties are aromatic carbocycles. Unless otherwise specified, "substituted aryl" refers to any aryl moiety having one or more of its hydrogens replaced with one or more substituents chosen from halogen, C₁₋₆-alkyl, C₁₋₆-haloalkyl, C₁₋₆-alkoxy, C₁₋₆-haloalkoxy, phenyl, and phenoxy, and preferably from halogen, C₁₋₆-alkyl, and phenyl. Preferably, a substituted aryl has from 1 to 3 substituents, and more preferably 1 or 2 substituents. As used herein, the term "polymer" includes oligomers. It will be appreciated by those skilled in the art that where the number of substituents on an aromatic ring in any of the formulas contained herein is less than the number of possible substituents, that the remaining aromatic atoms are substituted with hydrogen. The term "oligomer" refers to dimers, trimers, tetramers and other polymeric materials that are capable of further curing. By the term "curing" is meant any process, such as polymerization or condensation, that increases the overall molecular weight of the present oligomers, removes solubility enhancing groups from the present oligomers, or both increases the overall molecular weight and removes solubility enhancing groups. "Curable" refers to any material capable of being cured under certain conditions.

Polymers of the present invention comprise polymerized units of one or more compounds having two or more, and preferably two, cyclopentadienone moieties as a first monomer and one or more aromatic compounds having two or more ethynyl moieties and one or more solubility enhancing (i.e., polar) moieties as a second monomer. Preferably, the second monomers have two ethynyl moieties and one or more solubility enhancing moieties. The second monomers preferably have from 1 to 3 solubility enhancing moieties, and more preferably 1 or 2 solubility enhancing moieties. Optionally, the polymers of the invention may further include as polymerized units one or more third monomers, where the third monomer is an aromatic compound having two or more ethynyl moieties and being free of solubility enhancing moieties. In still another option, the present polymers may comprise as polymerized units one or more end capping monomers. Preferred polymers of the present invention are oligomers.

Any monomer containing two or more cyclopentadienone moieties may suitably be used as the first monomer to prepare the present polymers. Alternatively, a mixture of two or more different monomers, each having two or more cyclopentadienone moieties, may be used as the first monomer. Preferably, one first monomer is used. Suitable cyclopentadienone moieties are well-known in the art, such as those described in U.S. Pat. Nos. 5,965,679; 6,288,188; and 6,646,081; and in Int. Pat. Pubs. WO 97/10193 and WO 2004/073824. It is preferred that the first monomer has the structure shown in formula (9) 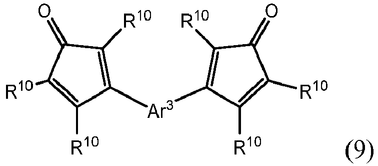 wherein each R¹⁰ is independently chosen from H, C₁₋₆-alkyl, and substituted or unsubstituted C₅₋₁₀-aryl; and Ar³ is an aromatic moiety having from 5 to 60 carbons. In formula (9), "substituted C₅₋₁₀-aryl" refers to a C₅₋₁₀-aryl having one or more iof its hydrogens replaced with one or more of halogen, C₁₋₁₀-alkyl, C₅₋₁₀-aryl, or a heteroatom-containing radical having from 0 to 20 carbon atoms and one or more heteroatoms chosen from O, S and N. Exemplary heteroatom-containing radicals having from 0 to 20 carbon atoms and one or more heteroatoms chosen from O, S and N include, without limitation, hydroxy, carboxy, amino, C₁₋₂₀-amido, C₁₋₁₀-alkoxy, C₁₋₂₀-hydroxyalkyl, C₁₋₃₀-hydroxy(alkyleneoxy), and the like. Preferably, each R¹⁰ is independently chosen from C₃₋₆-alkyl, phenyl and substituted phenyl, and more preferably each R¹⁰ is phenyl or substituted phenyl. As used herein, "substituted phenyl" refers to a phenyl moiety substituted with one or more of halogen, C₁₋₁₀-alkyl, C₅₋₁₀-aryl, or a heteroatom-containing radical having from 0 to 20 carbon atoms and one or more heteroatoms chosen from O, S and N. A wide variety of aromatic moieties are suitable for use as Ar³, such as those disclosed in U.S. Pat. No. 5,965,679. Preferably, Ar³ has from 5 to 40 carbons, and more preferably from 6 to 30 carbons. Exemplary aromatic moieties useful for Ar³ include those having the structure shown in formula (10) 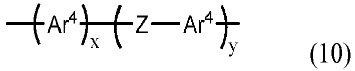 wherein x is an integer chosen from 1, 2 or 3; y is an integer chosen from 0, 1, or 2; each Ar⁴ is independently chosen from 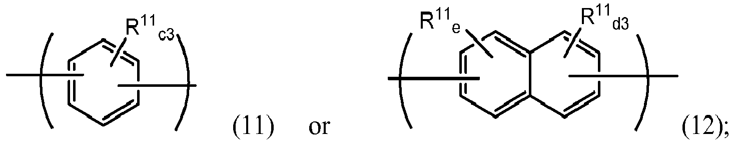 each R¹¹ is independently chosen from halogen, C₁₋₆-alkyl, C₁₋₆-haloalkyl, C₁₋₆-alkoxy, C₁₋₆-haloalkoxy, phenyl, and phenoxy; c3 is an integer from 0 to 4; each of d3 and e is an integer from 0 to 3; each Z is independently chosen from a single covalent chemical bond, O, S, NR¹², PR¹², P(-O)R¹², C(=O), C(R¹³)(R¹⁴), and Si(R¹³)(R¹⁴); R¹², R¹³, and R¹⁴ are independently chosen from H, C₁₋₄-alkyl, C₁₋₄-haloalkyl, and phenyl. It is preferred that x is 1 or 2, and more preferably 1. It is preferred that y is 0 or 1, and more preferably 1. Preferably, each R¹¹ is independently chosen from halogen, C₁₋₄-alkyl, C₁₋₄-haloalkyl, C₁₋₄-alkoxy, C₁₋₄-haloalkoxy, and phenyl, and more preferably from fluoro, C₁₋₄-alkyl, C₁₋₄-fluoroalkyl, C₁₋₄-alkoxy, C₁₋₄-fluoroalkoxy, and phenyl. It is preferred that c3 is from 0 to 3, more preferably from 0 to 2, and yet more preferably 0 or 1. It is preferred that each of d3 and e is independently 0 to 2, and more preferably 0 or 1. In formula (12), it is preferred that d3 + e = 0 to 4, and more preferably 0 to 2. Each Z is preferably independently chosen from O, S, NR¹², C(=O), C(R¹³)(R¹⁴), and Si(R¹³)(R¹⁴), more preferably from O, S, C(=O), and C(R¹³)(R¹⁴), and yet more preferably from O, C(=O), and C(R¹³)(R¹⁴). It is preferred that each R¹², R¹³, and R¹⁴ are independently chosen from H, C₁₋₄-alkyl, C₁₋₄-fluoroalkyl, and phenyl; and more preferably from H, C₁₋₄-alkyl, C₁₋₂-fluoroalkyl, and phenyl. Preferably, each Ar⁴ has the formula (11).

The one or more polyalkynyl-substituted second monomers of the present polymers have the formula (1): 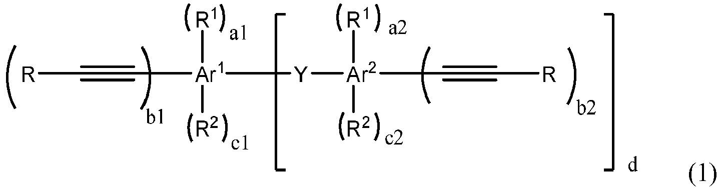 each Ar¹ and Ar² is independently a C₅₋₃₀ aryl moiety; each R is independently chosen from H, and optionally substituted C₅₋₃₀ aryl; each R¹ is independently chosen from - OH, C₁₋₆-hydroxyalkyl, -C(=O)OR³, -C(=O)N(R⁴)₂, -O-C(=O)R⁵, -NR⁴C(=O)R⁶,-N(R⁴)₃⁺ An⁻, -NO₂; -S(=O)₂-OR⁷, -O-S(=O)₂-R⁸, -NR⁴-S(=O)₂-R⁶, and S(=O)₂-N(R⁴)₂; each R² is independently chosen from C₁₋₁₀-alkyl, C₁₋₁₀-haloalkyl, C₁₋₁₀-hydroxyalkyl, C₁₋₁₀-alkoxy, CN, N(R⁴)₂, and halo; R³ = H, C₁₋₁₀-alkyl, C₁₋₁₀-hydroxyalkyl, C₁₋₁₀-aminoalkyl, C₆₋₃₀-aryl, or M; each R⁴ is independently H, C₆₋₃₀-aryl, or C₁₋₁₀-alkyl; each R⁵ is independently chosen from H, C₁₋₁₀-alkyl, C₁₋₁₀-hydroxyalkyl, C₆₋₃₀-aryl, -O(C₁₋₁₀-alkyl), -O(C₆₋₁₀-aryl) and-N(R⁴)₂; R⁶ = H, C₁₋₁₀-alkyl, C₁₋₁₀-hydroxyalkyl, C₆₋₃₀-aryl, -O(C₁₋₁₀-alkyl), or -NH(C₁₋₁₀-alkyl); R⁷ = H, C₁₋₁₀-alkyl, C₆₋₃₀-aryl, or M; R⁸ = C₆₋₃₀-aryl, C₁₋₁₀-alkyl, or C₁₋₁₀-haloalkyl; M = an alkali metal ion, an alkaline earth metal ion, or an ammonium ion; An⁻ is an anion chosen from halide and C₁₋₂₀-carboxylate; each Y is independently a single covalent chemical bond or a divalent linking group chosen from -O-, -S-, -S(=O)-, -S(=O)₂-, -C(=O)-, -(C(R⁹)₂)_{z-}, C₆₋₃₀-aryl, and -(C(R⁹)₂)_{z1}-(C₆₋₃₀-aryl)-(C(R⁹)₂)_{z2}-; each R⁹ is independently chosen from H, hydroxy, halo, C₁₋₁₀-alkyl, C₁₋₁₀-haloalkyl, and C₆₋₃₀-aryl; a1 = 0 to 3; a2 = 0 to 3; b1 = 1 to 4; b2 = 0 to 2; c1 = 0 to 4; c2 = 0 to 4; a1 + a2 = 1 to 6; b1 + b2 = 2 to 6; c1 + c2 = 0 to 6; d = 0 to 2; z = 1 to 10; z1 = 0 to 10; z2 = 0 to 10; and z1 + z2 = 1 to 10. Each R is preferably independently chosen from H and C₆₋₂₀-aryl, more preferably from H and C₆₋₁₀ aryl, and yet more preferably from H and phenyl. R¹ is a solubility enhancing moiety. It is preferred that each R¹ is independently chosen from -OH, C₁₋₄-hydroxyalkyl,-C(=O)OR³, -C(=O)N(R⁴)₂, -O-C(=O)R⁵, -S(=O)₂-OR⁶, and S(=O)₂-N(R⁴)_{2'} more preferably from -OH, C₁₋₄-hydroxyalkyl, -C(=O)OR³ and -C(=O)N(R⁴)₂, and yet more preferably -OH and -C(=O)OH. It is preferred that each R² is independently chosen from C₁₋₁₀-alkyl, C₁₋₁₀-haloalkyl, C₁₋₁₀-hydroxyalkyl, C₁₋₁₀-alkoxy, N(R⁴)₂, and halo, and more preferably from C₁₋₁₀-alkyl, C₁₋₁₀-haloalkyl, and halo. Preferably, R³ is H, C₁₋₆-alkyl, C₁₋₆-hydroxyalkyl, C₁₋₆-aminoalkyl, C₆₋₃₀-aryl, or M, more preferably H, C₁₋₄-alkyl, C₁₋₆-hydroxyalkyl, or M, and even more preferably H. R⁴ is preferably H, C₆₋₃₀-aryl, or C₁₋₆-alkyl, and more preferably H or C₁₋₄-alkyl. It is preferred that R⁵ is C₁₋₆-alkyl, C₁₋₆-hydroxyalkyl, C₆₋₃₀-aryl, -O(C₁₋₁₀-alkyl), or -N(R⁴)₂, and more preferably C₁₋₆-alkyl, C₁₋₆-hydroxyalkyl, C₆₋₂₀-aryl, -O(C₁₋₆-alkyl), or -N(R⁴)₂. R⁶ is preferably H, C₁₋₁₀-alkyl, C₁₋₆-hydroxyalkyl, C₆₋₂₀-aryl, -O(C₁₋₁₀-alkyl), or -N(R⁴)₂, and more preferably H, C₁₋₆-alkyl, -O(C₁₋₆-alkyl), or -N(R⁴)₂. R⁷ is preferably H, C₁₋₆-alkyl, C₆₋₂₀-aryl, or M, more preferably H, C₁₋₄-alkyl, or M, and even more preferably H or M. Preferably, each Y is independently a single covalent chemical bond or a divalent linking group chosen from -O-, -S-, -S(=O)-, -S(=O)₂-, -C(=O)-, -(C(R⁹)₂)_{z}-, and C₆₋₃₀-aryl, and more preferably a single covalent chemical bond, -O-, -S-, -S(=O)₂-, -C(=O)-, and -(C(R⁹)₂)_{z}-. It is preferred that R⁸ is C₆₋₂₀-aryl, C₁₋₁₀-alkyl, or C₁₋₁₀-fluoroalkyl, and more preferably phenyl, tolyl, methyl, or trifluoromethyl. R⁹ is preferably H, halo, C₁₋₁₀-alkyl, C₁₋₁₀-haloalkyl, or C₆₋₃₀-aryl, and more preferably fluoro, C₁₋₆-alkyl, C₁₋₆-fluoroalkyl, or C₆₋₂₀-aryl. Any suitable ammonium ion may be used for M, such as those of the formula [NA_{4]}⁺ wherein each A is independently chosen from H, C₁₋₆-alkyl, C₇₋₁₀-aralkyl and C₆₋₈-aryl. Exemplary ammonium ions include, without limitation, ammonium, tetramethylammonium, tetraethylammonium, tetrabenzylammonium, and tetraphenylammonium. Preferred alkali metal ions for M are lithium ions, sodium ions or potassium ions. Preferred alkaline earth ions for M are magnesium ions or calcium ions. M is preferably chosen from lithium ions, sodium ions, potassium ions, magnesium ions, calcium ions and ammonium ions, more preferably from lithium ions, sodium ions, potassium ions, and ammonium ions, and even more preferably from lithium ions, sodium ions, potassium ions, and ammonium ions of the formula [NA₄]⁺ wherein each A is independently chosen from H, C₁₋₆-alkyl, C₇₋₁₀-aralkyl and C₆₋₈-aryl. More preferably, M is chosen from alkali metal ions and ammonium ions. An⁻ is preferably chosen from halide and C₁₋₁₀-carboxylate, and more preferably halide and C₁₋₆-carboxylate. Preferably, a1 = 1 to 3, more preferably 1 to 2, and most preferably a1 = 1. It is preferred that a2 = 0 to 2. Preferably, a1 + a2 = 1 to 4, more preferably 1 to 3, and yet more preferably 1 to 2. It is preferred that b1 = 1 to 2, and more preferably 2. It is preferred that b2 = 0 or 1. Preferably, b1 + b2 = 2 to 4, and more preferably 2 or 3, and even more preferably 2. Preferably c1 = 0 to 3, and more preferably 0 to 2. It is preferred that c2 is 0 to 3, and more preferably 0 to 2. Preferably, c1 + c2 is 0 to 3, more preferably 0 to 2, and even more preferably 0. It is preferred that d = 0 or 1, and more preferably 0. Preferably, z = 1 to 6, more preferably 1 to 3, and even more preferably z = 1. Preferably, z1 and z2 are each 0 to 5. It is preferred that z1 + z2 = 1 to 6, and more preferably 2 to 6.

Suitable aryl moieties for Ar¹ and Ar² include, but are not limited to, pyridyl, phenyl, naphthyl, anthracenyl, phenanthryl, pyrenyl, coronenyl, tetracenyl, pentacenyl, tetraphenyl, benzotetracenyl, triphenylenyl, perylenyl, biphenyl, binaphthyl, diphenyl ether, and dinaphthyl ether. It is preferred that Ar¹ and each Ar² in formula (1) are independently a C₆₋₂₀ aryl moiety. Preferred aryl moieties for Ar¹ and each Ar² are phenyl, naphthyl, anthracenyl, phenanthryl, pyrenyl, tetracenyl, pentacenyl, tetraphenyl, triphenylenyl, and perylenyl.

Preferred second monomers are those of formulas (2) and (3): 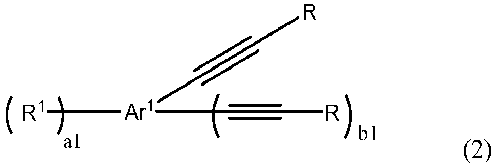 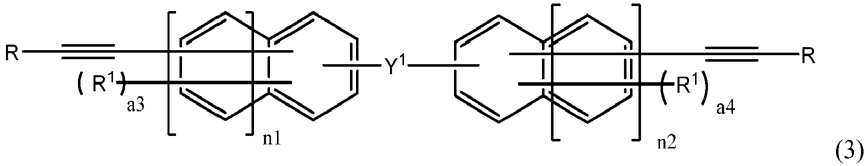 wherein Ar¹, R, R¹, a1 and b1 are as defined above; a3 is 1 or 2; a4 is 0 to 2; each of n1 and n2 is independently 0 to 4; and Y¹ is a single covalent chemical bond, O, S, S(=O)₂, C(=O), C(CH₃)₂, CF₂, and C(CF₃)₂. It will be appreciated by those skilled in the art that the brackets ("[]") in formula (3) refer to the number of aromatic rings fused to the phenyl ring. Accordingly, when n1 (or n2) = 0, the aromatic moiety is phenyl; when n1 (or n2) = 1, the aromatic moiety is naphthyl; when n1 (or n2) = 2, the aromatic moiety may be anthracenyl or phenanthryl; when n1 (or n2) = 3, the aromatic moiety may be tretacenyl, tetraphenyl, triphenylenyl, or pyrenyl; and when n1 (or n2) = 4, the aromatic moiety may be perylenyl or benzotetracenyl. In formula (2), a1 is preferably 1 to 2, and more preferably a1 = 1. It is preferred that b1 in formula (2) is 1 or 2, and more preferably 1. R is preferably H or phenyl. R¹ in each of formulas (2) and (3) is preferably -OH, C₁₋₆-hydroxyalkyl, -C(=O)OR³, -C(=O)N(R⁴)₂, -O-C(=O)R⁵,-S(=O)₂-OR⁶, or S(=O)₂-N(R⁴)₂, more preferably from -OH, C₁₋₄-hydroxyalkyl,-C(=O)OH or -C(=O)N(R⁴)₂, and yet more preferably -OH or -C(=O)OH. Ar¹ in formula (2) is preferably phenyl, naphthyl, anthracenyl, pyrenyl, and perylenyl, more preferably phenyl, naphthyl and pyrenyl, and even more preferably phenyl. In formula (3), it is preferred that n1 and n2 are independently chosen from 0, 1, 3, and 4, more preferably from 0, 1 and 3, and even more preferably from 1 and 3. It is further preferred that n1 = n2. In formula (3), Y¹ is preferably a single covalent chemical bond, O, S(=O)₂, C(=O), C(CH₃)₂, CF₂, or C(CF₃)₂, and more preferably a single covalent chemical bond.

Particularly preferred monomers of formula (2) are monomers of formulas (4) to (8): 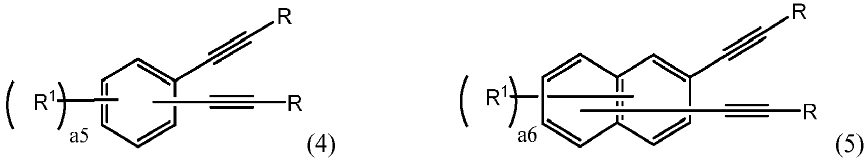 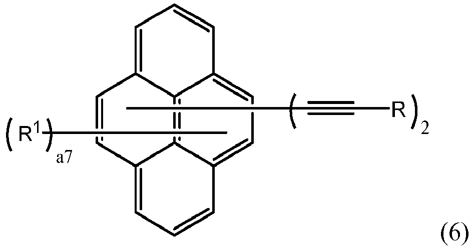 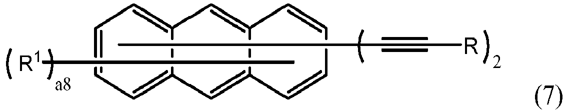 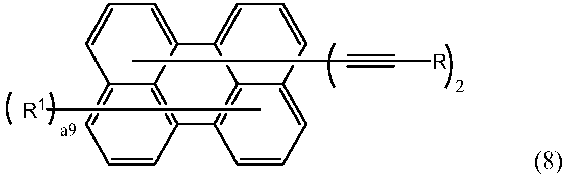 wherein R and R¹ are as described above; a5 = 1 or 2; and each of a6, a7, a8 and a9 are independently 1 to 4. Preferably, a5 = 1. It is preferred that a6 is 1 to 3, more preferably 1 or 2, and even more preferably 1. Preferably, each of a7 to a9 is independently 1 to 3, and more preferably 1 to 2. Compound (4) is more particularly preferred. Preferably, in compound (4), each R is independently H or phenyl, and more preferably each R is H or phenyl. More preferably, each R¹ in compound (4) is OH or -C(=O)-OH, and even more preferably -C(=O)-OH. It is preferred that a5 = 1 or 2, and more preferably a5 = 1.

In the monomers of formula (1), any two alkynyl moieties may have an ortho, meta or para relationship to each other, and preferably a meta or para relationship to each other. Preferably, the alkynyl moieties in the monomers of formula (1) do not have an ortho relationship to each other. Suitable monomers of formula (1) are generally commercially available or may be readily prepared by methods known in the art.

The present polyarylene polymers may be comprised of one monomer of formula (1), or a mixture of two or more monomers of formula (1). Monomers of formula (2) are preferred second monomers. It is preferred that the present polymers are comprised of polymerized units of one or more monomers of formula (2). In an alternate preferred embodiment, the present polymers are comprised of polymerized units of one or more monomers of formula (3), or in yet another alternate embodiment of one or more monomers of formula (2) and one or more monomers of formula (3). Mixtures of polymers comprising as polymerized units one or more monomers of formula (1) may suitably be used.

One or more optional third monomers which may be used to form the present polymers are polyalkynyl-substituted monomers that are free of a solubility enhancing moiety. Such optional third monomers are those of formula (13) 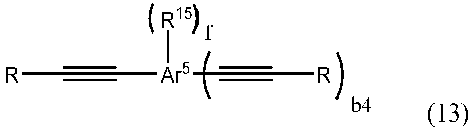 wherein each R is as defined above for the monomers of formula (1); Ar⁵ is a C₅₋₃₀-aromatic moiety; each R¹⁵ is independently chosen from C₁₋₄-alkyl, C₁₋₄-haloalkyl, C₁₋₄-alkoxy, optionally substituted C₇₋₁₄-aralkyl, and optionally substituted C₆₋₁₀-aryl; b4 = 1 or 2; and f = 0 to 4. "Substituted aralkyl" refers to an aralkyl moiety having one or more of its hydrogens replaced with one or more substituents chosen from halogen, C₁₋₆-alkyl, C₁₋₆-haloalkyl, C₁₋₆-alkoxy, C₁₋₆-haloalkoxy, phenyl, and phenoxy, preferably from halogen, C₁₋₆-alkyl, C₁₋₄-haloalkyl, C₁₋₆-alkoxy, C₁₋₄-haloalkoxy, and phenyl, and more preferably from halogen, C₁₋₆-alkyl, C₁₋₆-alkoxy, phenyl, and phenoxy. Fluorine is the preferred halogen. In formula (13), it is preferred that each R is independently H or C₆₋₁₀-aryl, and more preferably H or phenyl. It is preferred that each R¹⁵ is independently chosen from C₁₋₄-alkyl, C₁₋₄-fluoroalkyl, C₁₋₄-alkoxy, benzyl, phenethyl, phenyl, naphthyl, substituted phenyl and substituted naphthyl, more preferably from C₁₋₂-alkyl, C₁₋₄-fluoroalkyl, C₁₋₂-alkoxy, phenyl, and substituted phenyl, and yet more preferably from C₁₋₂-alkyl, C₁₋₄-fluoroalkyl, C₁₋₂-alkoxy, and phenyl. Preferably, b4 = 2. Preferably, f = 0 to 3, more preferably 0 to 2, and yet more preferably f = 0. Ar⁵ may be any suitable C₅₋₃₀-aromatic moiety, such as, without limitation, pyridyl, phenyl, naphthyl, anthracenyl, phenanthryl, tetracenyl, pyrenyl, perylenyl, coronenyl, pentacenyl, triphenylenyl, tetraphenyl, benzotetracenyl, biphenyl, binaphthyl, diphenyl ether, and dinaphthyl ether. Preferably, optional monomers of formula (13) comprise 2 or 3 alkynyl moieties having a terminal hydrogen or terminal phenyl moiety. Any 2 alkynyl moieties in the monomers of formula (13) may have an ortho, meta or para relationship to each other, and preferably a meta or para relationship to each other. Preferably, the alkynyl moieties do not have an ortho relationship to each other. A single optional monomer of formula (13) may be used to prepare the present polymers, or two or more optional monomers of formula (13) but different from each other may be used. When a single optional monomer of formula (13) is used, it is preferred that b4 = 2. In one preferred embodiment, the present polymers further comprise as polymerized units a monomer of formula (13), and more preferably a monomer of formula (13) wherein b4 = 2. In an alternate preferred embodiment, the present polymers further comprise as polymerized units one monomer of formula (13) wherein b4 = 1. Preferably, the present polymers do not contain such polyalkynyl-substituted monomers free of a solubility enhancing (or polar) moiety.

Compounds useful as the third monomers of formula (13) are generally commercially available, or may be prepared by methods known in the art. Preferred optional monomers of formula (13) are: 1,3-diethynylbenzene; 1,4-diethynylbenzene; 4,4'-diethynyl-1,1'-biphenyl; 3,5-diethynyl-1,1'-biphenyl; 1,3,5-triethynylbenzene; 1,3-diethynyl-5-(phenylethynyl)benzene; 1,3-bis(phenylethynyl)benzene; 1,4-bis(phenylethynyl)benzene; 1,3,5-tris(phenylethynyl)benzene; 4,4'-bis(phenylethynyl)-1,1'-biphenyl; 4,4'-diethynyl-diphenylether; and mixtures thereof. More preferably, the monomers of formula (13) are chosen from: 1,3-diethynylbenzene; 1,4-diethynylbenzene; 1,3,5-triethynylbenzene; 4,4'-diethynyl-1,1'-biphenyl; 1,3-bis(phenylethynyl)-benzene; 1,4-bis(phenylethynyl)benzene; 4,4'-bis(phenylethynyl)-1,1'-biphenyl; and mixtures thereof. Even more preferably, the second monomers are chosen from: 1,3-diethynylbenzene; 1,4-diethynylbenzene; 4,4'-diethynyl-1,1'-biphenyl; 1,3,5-triethynylbenzene; and mixtures thereof.

Optionally, one or more end capping monomers may be used to prepare the present polyarylene polymers. Such end capping monomers have a single alkyne moiety and a solubility enhancing polar moieties and which function to cap one end, preferably two ends, and more preferably all ends, of the present polymers. Suitable monomers are those disclosed in U.S. Published Pat. App. 2016/0060393. It will be appreciated by those skilled in the art that reaction conditions can be selected such that these optional end capping monomers preferentially react with alkynyl moieties having terminal hydrogens (R = H) in the polymer over alkynyl moieties having terminal aryl moieties (R = C₅₋₂₀-aryl). Preferably, the polar moieties present in these optional end capping monomers are cleavable under conditions used to cure the present polyarylene polymers. Suitable optional end capping monomers are those of formula (14): 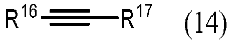 wherein R¹⁶ is H, optionally substituted C₁₋₁₀-alkyl, optionally substituted C₇₋₁₂-aralkyl, optionally substituted C₆₋₁₀-aryl, or R¹⁷; and R¹⁷ is a polar moiety. Suitable polar moieties are any hydrocarbyl moiety having from 1 to 20 carbon atoms and one or more functional groups chosen from -C(=O)-R¹⁸, -C(=O)OR¹⁸, -OH, -NO₂, and -NR¹⁸R¹⁹, where R¹⁸ and R¹⁹ are independently chosen from H, C₁₋₁₀-alkyl, C₇₋₁₆-aralkyl, and C₆₋₁₀-aryl. Preferably, the polar moiety is chosen from -C(=O)-R¹⁸, -C(=O)OR¹⁸, -OH, and -NR¹⁸R¹⁹, and more preferably from -C(=O)-R¹⁸, -C(=O)OR¹⁸, and -OH. Such-C(=O)-, -OH, and -NR¹⁸R¹⁹ functional groups may be part of another functional group, as in carboxylic acids, anhydrides, amides, ketones, esters, and the like. It is preferred that the polar moiety is chosen from carboxyl, C₂₋₁₂-aliphatic carboxylate, C₁₋₁₀-hydroxyalkyl, C₆₋₁₀-hydroxyaryl, C₇₋₂₀-aryl carboxylic acid, C₈₋₂₀-aryl carboxylic acid anhydride, C₇₋₂₀-aryl carboxylates, C₇₋₂₀-aryl amide, C₈₋₂₀-aryl imide, C₁₋₁₀-aminoalkyl, and C₆₋₂₀-arylamine. More preferably, the polar moiety is chosen from carboxyl, C₂₋₁₂-aliphatic carboxylate, C₁₋₁₀-hydroxyalkyl, C₆₋₁₀-hydroxyaryl, C₇₋₁₆-aryl carboxylic acid, and C₈₋₁₆-aryl carboxylic acid anhydride. Exemplary end capping monomers are: propiolic acid; acetylene dicarboxylic acid; phenyl propiolic acid; ethynyl benzoic acid; ethynyl phthalic acid; propargyl alcohol; propargylamine; 2-butyn-1,4-diol; 2-methyl-3-butyn-2-ol; 3-butyn-1-ol; 3-butyn-2-ol; 2-butyn-1-ol; 2-butynoic acid; ethynyl phenol; xylityl propiolate; ethynyl phthalic anhydride; ethynyl phthalimide; ethynyl benzamide; 2-butyn-1,4-diol diacetate; 3-butyn-2-one; 1-ethynyl-1-cyclohexanol; 1-ethynylcyclohexylamine; 1-ethynylcyclopentanol; ethynylaniline; N-(ethynylphenyl)acetamide; 2-carbamoyl-5-ethynylbenzoic acid; ethynyl-nitrobenzene; propiolamide; N-hydroxyl-propiolamide; 2-aminobut-3-ynoic acid; and mixtures thereof. Preferred end capping monomers are: propiolic acid; acetylene dicarboxylic acid; phenyl propiolic acid; ethynyl benzoic acid; ethynyl phthalic acid; propargyl alcohol; 2-butyn-1,4-diol; 2-methyl-3-butyn-2-ol; 3-butyn-1-ol; 3-butyn-2-ol; 2-butyn-1-ol; 2-butynoic acid; ethynyl phenol; xylitylpropiolate; ethynyl phthalic anhydride; 2-butyn-1,4-diol diacetate; and mixtures thereof. Such end capping monomers are generally commercially available, or may be prepared by methods known in the art. Preferably, the present polymers are free of such end-capping monomers.

The polyarylene polymers of the invention have a number average molecular weight (Mₙ) of 10,000 to 50,000 Da, a weight average molecular weight (M_{w}) of 30,000 to 150,000 Da, and a polydispersity index (PDI) of 1 to <6, such as from 1 to 5.9. PDI = M_{w}/Mₙ. The Mₙ and M_{w} of the present polymers are determined by the conventional technique of gel permeation chromatography (GPC) against polystyrene standards using uninhibited tetrahydrofuran (THF) as eluting solvent at 1.2 mL/min and a refractive index (RI) detector. Preferably, the present polymers have a PDI of 1 to 4.5, more preferably 1 to 4, and even more preferably from 1 to 3.5. Preferred polyarylene polymers have a M_{w} of from 50,000 to 150,000, more preferably from 60,000 to 150,000, even more preferably from 75,000 to 150,000, and yet more preferably from 75,000 to 135,000 Da. It is preferred that the present polymers have an Mₙ of 20,000 to 50,000 Da. It is further preferred that the present polymers have an Mₙ of 10,000 to 50,000 Da, a M_{w} of 50,000 to 150,000 Da, and a PDI of 1 to 4.5. More preferably, the present polymers have an Mₙ of 20,000 to 50,000 Da, a M_{w} of 60,000 to 150,000 Da, and a PDI of 1 to 4. It has been found that when the polyalkynyl-substituted second monomers of formula (1) are used as the only polyalkynyl-substituted monomer to form the present polymers according to conventional Diels-Alder conditions, the resulting polyarylene polymers have relatively lower Mₙ and M_{w}, and/or higher PDI values, such as >6.

The polymers of the present invention are prepared by stepwise polymerization of the first and second monomers. In such stepwise polymerization, the one or more first monomers and a suitable solvent are added to a reaction vessel. Then, a first portion of the one or more second monomers are added to the reaction vessel and allowed to react, where such first portion is less than 1 equivalent based on the total amount of the one or more first monomers. The second monomer may be added neat or in admixture with one or more organic solvents. The second monomer may be added over a period of time, such as from 0.25 to 6 hours, to reduce exotherm formation, but is preferably added at one time. In one embodiment, the first monomer and organic solvent mixture is heated to the desired reaction temperature before the second monomer is added. Next, one or more additional portions of the one or more second monomers are added to the reaction vessel in separate steps, allowing each portion to react before adding the next portion of the second monomer. The sum of the first portion and all additional portions is equal to 0.8 to 1.2, and preferably from 0.85 to 1.15, equivalents based on the total moles of the one or more first monomers. In the preparation of the present polymers, the polyalkynyl-substituted second monomer is added to the reaction mixture in any number of aliquots greater than 1. That is, the polyalkynyl-substituted second monomer is added to the reaction mixture in at least two aliquots (or portions), preferably in at least 3 aliquots, and more preferably in at least four aliquots. It will be appreciated that any number of aliquots greater than one, such as from 2 to 10, may be used. Preferably, 2 to 6 aliquots are used, more preferably 3 to 6 aliquots, even more preferably 4 to 6 aliquots, and most preferably 4 aliquots are used. It is preferred that the time interval between aliquot addition is 15 to 400 minutes, more preferably 30 to 200 minutes and even more preferably 45 to 90 minutes. It is also preferred that the reaction mixture be allowed to react for 2 to 12 hours after addition of the final aliquot of polyalkynyl-substituted second monomer, and more preferably for 4 to 10 hours. The present polymerization temperature is preferably less than or equal to 200 °C, more preferably from 100 to 165 °C, and even more preferably from 125 to 160 °C. Such stepwise polymerization is critical to producing the present polymers having a relatively high M_{w}, such as greater than 30,000 Da, and preferably greater than or equal to 50,000 Da, and a relatively low PDI, such as from 1 to <6, and preferably from 1 to 3.5. When one or more third monomers are used, such third monomers are typically combined with the one or more second monomers or alternatively, the second and third monomers may be added alternatingly. The first and second monomers may react at temperatures below those conventionally used to make polyarylene polymers by a Diels-Alder type reaction. While not wishing to be bound by theory, it is believed that the presence of the solubility enhancing moiety activates the monomer such that the Diels-Alder reaction is facilitated at a lower temperature. The reaction may be carried out under oxygen-containing atmosphere, but an inert atmosphere is preferred. Following the reaction, the resulting polymer may be isolated from the reaction mixture, diluted with appropriate solvent, or used as is for coating a surface.

The present invention also provides a method of preparing a polyarylene polymer comprising: (a) reacting a molar amount of a first monomer comprising two or more cyclopentadienone moieties with a first portion of a molar amount of a second monomer formula (1): 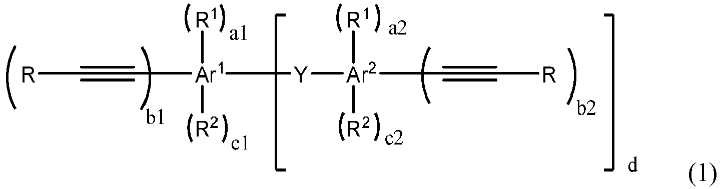 wherein each Ar¹ and Ar² is independently a C₅₋₃₀-arylmoiety; each R is independently chosen from H, and optionally substituted C₅₋₃₀-aryl; each R¹ is independently chosen from -OH, C₁₋₆-hydroxyalkyl, -C(=O)OR³, -C(=O)N(R⁴)₂, -O-C(=O)R,⁵-NR⁴C(=O)R⁶, -N(R⁴)₃⁺ An⁻, -NO₂; -S(=O)₂-OR⁷, -O-S(=O)₂-R⁸, -NR⁴-S(=O)₂-R⁶, and S(=O)₂-N(R⁴)₂; each R² is independently chosen from C₁₋₁₀-alkyl, C₁₋₁₀-haloalkyl, C₁₋₁₀-hydroxyalkyl, C₁₋₁₀-alkoxy, CN, N(R⁴)₂, and halo; R³ = H, C₁₋₁₀-alkyl, C₁₋₁₀-hydroxyalkyl, C₁₋₁₀-aminoalkyl, C₆₋₃₀-aryl, or M; each R⁴ is independently H, C₆₋₃₀-aryl, or C₁₋₁₀-alkyl; each R⁵ is independently chosen from H, C₁₋₁₀-alkyl, C₁₋₁₀-hydroxyalkyl, C₆₋₃₀-aryl, -O(C₁₋₁₀-alkyl), -O(C₆₋₁₀-aryl) and -N(R⁴)₂; R⁶ = H, C₁₋₁₀-alkyl, C₁₋₁₀-hydroxyalkyl, C₆₋₃₀-aryl, -O(C₁₋₁₀-alkyl), or -NH(C₁₋₁₀-alkyl); R⁷ = H, C₁₋₁₀-alkyl, C₆₋₃₀-aryl, or M; R⁸ = C₆₋₃₀-aryl, C₁₋₁₀-alkyl, or C₁₋₁₀-haloalkyl; M = an alkali metal ion, an alkaline earth metal ion, or an ammonium ion; An⁻ is an anion chosen from halide and C₁₋₂₀-carboxylate; each Y is independently a single covalent chemical bond or a divalent linking group chosen from -O-, -S-, -S(=O)-, -S(=O)₂-, -C(=O)-, - (C(R⁹)₂)_{z}-, C₆₋₃₀-aryl, and -(C(R⁹)₂)_{z1}-(C₆₋₃₀-aryl)-(C(R⁹)₂)_{z2}-; each R⁹ is independently chosen from H, hydroxy, halo, C₁₋₁₀-alkyl, C₁₋₁₀-haloalkyl, and C₆₋₃₀-aryl; a1 = 0 to 3; a2 = 0 to 3; b1 = 1 to 4; b2 = 0 to 2; c1 = 0 to 4; c2 = 0 to 4; a1 + a2 = 1 to 6; b1 + b2 = 2 to 6; c1 + c2 = 0 to 6; d = 0 to 2; z = 1 to 10; z1 = 0 to 10; z2 = 0 to 10; and z1 + z2 = 1 to 10; then (b) reacting the molar amount of the first monomer with a second portion of the second monomer; and (c) optionally repeating step (b) with one or more additional portions of the second monomer; wherein the first portion of the second monomer is less than 1 equivalent based on the molar amount of the first monomer; wherein the sum of the first portion, the second portion and any optional addition portions of the second monomer is from 0.8 to 1.2 molar equivalents based on the molar amount of the first monomer; and wherein the polyarylene polymer has a Mₙ of 10,000 to 50,000 Da, a M_{w} of 10,000 to 150,000 Da, and a PDI of 1 to <6.

The polymers of the present invention are prepared by reacting one or more first monomers having two or more cyclopentadienone moieties, one or more second monomers of formula (1), and optionally one or more additional monomers, such as the optional monomers of formulae (13) and/or (14) discussed above, in a suitable organic solvent. The total first monomers (that is, monomers containing cyclopentadienone moieties) mole ratio of the total second monomers (that is, alkyne-containing monomers) to is from 1:0.8 to 1:1.2, and preferably from 1:0.85 to 1:11.5. When an optional third monomer is used, the molar ratio of the total second monomer to the total third monomer is from 0.1:1 to 1: 0.1, preferably from 0.25:1 to 1:0.25, more preferably from 0.3:1 to 1:0.3, yet more preferably from 0.5:1 to 1:0.5, and even more preferably from 0.4:0.6 to 0.75:0.25. When an optional end capping monomer is used, it is typically used in a total amount of from 0.05 to 0.25 moles, based on 1 mole of the first monomer, preferably from 0.075 to 0.2 moles, and more preferably from 0.09 to 0.125 moles. Suitable organic solvents useful to prepare the present oligomers are benzyl esters of C₂₋₆-alkanecarboxylic acids, dibenzyl esters of C₂₋₆-alkanedicarboxylic acids, tetrahydrofurfuryl esters of C₂₋₆-alkanecarboxylic acids, ditetrahydrofurfuryl esters of C₂₋₆-alkanedicarboxylic acids, phenethyl esters of C₂₋₆-alkanecarboxylic acids, diphenethyl esters of C₂₋₆-alkanedicarboxylic acids, aromatic ethers, carbonates, and lactones. Preferred aromatic ethers are diphenyl ether, dibenzyl ether, C₁₋₆-alkoxy-substituted benzenes and benzyl C₁₋₆-alkyl ethers, and more preferably C₁₋₄-alkoxy-substituted benzenes and benzyl C₁₋₄-alkyl ethers. Preferred organic solvents are benzyl esters of C₂₋₄-alkanecarboxylic acids, dibenzyl esters of C₂₋₄-alkanedicarboxylic acids, tetrahydrofurfuryl esters of C₂₋₄-alkanecarboxylic acids, ditetrahydrofurfuryl esters of C₂₋₄-alkanedicarboxylic acids, phenethyl esters of C₂₋₄-alkanecarboxylic acids, diphenethyl esters of C₂₋₄-alkanedicarboxylic acids, C₁₋₆-alkoxy-substituted benzenes, and benzyl C₁₋₆-alkyl ethers, more preferably benzyl esters of C₂₋₆-alkanecarboxylic acids, tetrahydrofurfuryl esters of C₂₋₆-alkanecarboxylic acids, phenethyl esters of C₂₋₆-alkanecarboxylic acids, C₁₋₄-alkoxy-substituted benzenes, benzyl C₁₋₄-alkyl ethers, dibenzyl ether, carbonates, and lactones, and yet more preferably benzyl esters of C₂₋₆-alkanecarboxylic acids, tetrahydrofurfuryl esters of C₂₋₆-alkanecarboxylic acids, C₁₋₄-alkoxy-substituted benzenes, benzyl C₁₋₄-alkyl ethers, carbonates, and lactones. Exemplary organic solvents include, without limitation, benzyl acetate, benzyl proprionate, tetrahydrofurfuryl acetate, tetrahydrofurfuryl propionate, tetrahydrofurfuryl butyrate, anisole, methylanisole, dimethylanisole, dimethoxybenzene, ethylanisole, ethoxybenzene, xylene, mesitylene, cumene, limonene, benzyl methyl ether, benzyl ethyl ether, and propylene carbonate, and preferably benzyl acetate, benzyl proprionate, tetrahydrofurfuryl acetate, tetrahydrofurfuryl propionate, tetrahydrofurfuryl butyrate, anisole, methylanisole, dimethylanisole, dimethoxybenzene, ethylanisole, ethoxybenzene, xylene, mesitylene, cumene, limonene, propylene carbonate, and gamma-butyrolactone.

While not intending to be bound by theory, it is believed that the present polyarylene polymers are formed through the Diels-Alder reaction of the cyclopentadienone moieties of the first monomer with the alkynyl moieties of the second monomer and the alkynyl moieties of any optional third monomers and the alkynyl moieties of any optional end capping monomers upon heating. During such Diels-Alder reaction, a carbonyl-bridged species forms. It will be appreciated by those skilled in the art that such carbonyl-bridged species may be present in the oligomers. Upon further heating, the carbonyl bridging species will be essentially fully converted to an aromatic ring system. Due to the mole ratio of the monomers used, the present polymers contain arylene rings in the polymer backbone which are substituted with at least one solubility enhancing moiety as illustrated in the following reaction scheme, where A is the first monomer and B is the second monomer.

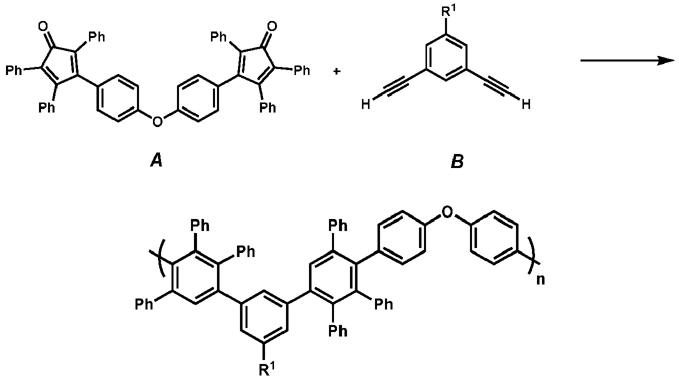

The present polymer in the organic reaction solvent can be directly cast as a film, applied as a coating or poured into a non-solvent to precipitate the oligomer or polymer. Water, methanol, ethanol isopropanol and other similar polar liquids, such as glycol ethers, or mixtures thereof are typical non-solvents which can be used to precipitate the polymer. Solid polymer may be dissolved and processed from a suitable organic solvent described above, or from organic solvents typically used in the electronics industry, such as propylene glycol methyl ether (PGME), propylene glycol methyl ether acetate (PGMEA), methyl 3-methoxypropionate (MMP), ethyl lactate, n-butyl acetate, anisole, N-methyl pyrrolidone, gamma-butyrolactone (GBL), ethoxybenzene, benzyl propionate, benzyl benzoate, propylene carbonate, xylene, mesitylene, cumene, limonene, and mixtures thereof. Mixtures of organic solvents are particularly preferred, such as a mixture comprising one or more of anisole, ethoxybenzene, PGME, PGMEA, GBL, MMP, n-butyl acetate, benzyl propionate and benzyl benzoate in combination with one or more additional organic solvents, and more preferably a mixture comprising two or more of anisole, ethoxybenzene, PGME, PGMEA, GBL, MMP, n-butyl acetate, benzyl propionate, xylene, mesitylene, cumene, limonene, and benzyl benzoate. When a mixture of solvents is used, the ratio of solvents is generally not critical and may vary from 99:1 to 1:99 w/w, provided that the solvent mixture is able to dissolve the present polymer. The solubility enhancing moieties in the backbone of the present polymers provide improved solubility as compared to polyarylene polymers without such solubility enhancing moieties. It will be appreciated by those skilled in the art that the concentration of the polymer in the organic reaction solvent may be adjusted by removing a portion of the organic solvent, or by adding more of the organic solvent, as may be desired.

In use, the composition comprising the present polymer and organic solvent may be coated by any suitable method on any suitable substrate surface. Suitable methods for coating the composition include, but are not limited to, spin-coating, curtain coating, spray coating, roller coating, doctor blading, bar coating, dip coating, slot die coating, and vapor deposition, among other methods. In the electronics manufacturing industry, spin-coating and slot-die coating are preferred methods to take advantage of existing equipment and processes. In spin-coating, the solids content of the composition may be adjusted, along with the spin speed, to achieve a desired thickness of the composition on the surface it is applied to. Typically, the present compositions are spin-coated at a spin speed of 400 to 4000 rpm. The amount of the composition dispensed on the wafer or substrate depends on the total solids content in the composition, the size of the substrate to be coated, the desired thickness of the resulting coating layer, and other factors well-known to those skilled in the art.

When the present polymer compositions are used to deposit a coating or film using certain techniques, such as spin-coating, the resulting coating may suffer from certain defects. While not wishing to be bound by theory, it is believed that such defects result from the condensation of moisture on the film surface due to evaporative cooling, and such moisture forces the oligomer out of solution, resulting in a non-uniform coating of oligomer on the surface. To address such defects, a secondary solvent, which is both water-miscible and miscible with the organic solvent used in the composition, may optionally be added to the present oligomer composition. It is believed that such secondary solvent prevents the formation of water droplets during deposition of the oligomer coating on the substrate. Such secondary solvent may be added to the present composition in any suitable amount, such as from 0 to 40 wt%, based upon the total weight of the composition, and preferably from 0 to 30 wt%. Ethyl lactate and gamma-butyrolactone are examples of such a secondary solvent. Optionally, one or more secondary additives may be added to the present compositions, such as a surfactant, which may be nonionic, cationic, anionic or amphoteric. Each such secondary additive may be added to the compositions in an amount of from 0 to 5 wt%, and preferably from 0 to 2 wt%.

In general, the present compositions comprise a polyarylene polymer of the invention, an organic solvent, and an optional secondary solvent, each as described above, wherein the polymer is present in an amount of 1 to 45% solids, and preferably from 5 to 35% solids. Such compositions can be used to deposit an oligomer coating on a substrate, where the polymer coating layer has a thickness of from 50 nm to 500 µm, preferably from 100 nm to 250µm, and more preferably from 100 nm to 125 µm, although such coatings may be thicker or thinner than these ranges depending on the particular application. In particular, the present compositions are suitable for depositing a polyarylene polymer layer having a thickness of 1 to 200 µm, preferably from 25 to 150 µm, and more preferably from 30 to 125 µm, in a single coating step.

Preferably, after being coated on a substrate surface, the polymer composition is heated (soft baked) to remove any organic solvent present. Typical baking temperatures are from 90 to 140 °C, although other suitable temperatures may be used. Such baking to remove residual solvent is typically done for approximately 30 sec. to 10 min., although longer or shorter times may suitably be used. Following solvent removal, a layer, film or coating of the polymer on the substrate surface is obtained. Preferably, the polymer is next cured, such as by heating to at a temperature of ≥ 300 °C, preferably ≥ 350 °C, and more preferably ≥ 400 °C. Such curing step may take from 2 to 180 min., preferably from 10 to 120 min., and more preferably from 15 to 60 min., although other suitable times may be used. In one embodiment, a belt furnace may be used to cure the polymer layer on a substrate. Upon curing, it is believed that the present polymers further polymerize. Such curing step may be performed in an oxygen-containing atmosphere, or in an inert atmosphere, and preferably in an inert atmosphere.

It is known that certain cured polyarylene films do not have good adhesion to substrate surfaces and require the use of an adhesion promoter, such as described in U.S. Pat. No. 5,668,210. Such adhesion promoter is typically applied to the substrate surface before the deposition of the polyarylene oligomer layer, which is subsequently cured to form the crosslinked polyarylene film. If it is desired to use an adhesion promoter, any suitable adhesion promoter for polyarylene films may be used, such as silanes, preferably organosilanes such as trimethoxyvinylsilane, triethoxyvinylsilane, hexamethyldisilazane [(CH₃)₃Si-NH-Si(CH₃)₃], or an aminosilane coupler such as gamma-aminopropyltriethoxysilane, or a chelate such as aluminum monoethylacetoacetatedi-isopropylate [((i-C₃H₇O)₂Al(OCOC₂H₅CHCOCH₃))]. In some cases, the adhesion promoter is applied from 0.01 to 5 wt% solution, excess solution is removed, and then the polyarylene oligomer is applied. In other cases, for example, a chelate of aluminum monoethylacetoacetatedi-isopropylate, can be incorporated onto a substrate by spreading a toluene solution of the chelate on a substrate and then baking the coated substrate at 350 °C for 30 min. in air to form a very thin (for example 5 nm) adhesion promoting layer of aluminum oxide on the surface. Other means for depositing aluminum oxide are likewise suitable. Alternatively, the adhesion promoter, in an amount of, for example, from 0.05 to 5 wt% based on the weight of the monomer, can be blended with the monomers before polymerization, negating the need for formation of an additional layer. Particularly suitable adhesion promoters include those sold under the AP 3000, AP 8000, and AP 9000S designations, available from Dow Electronic Materials (Marlborough, Massachusetts).

The presence of solubility enhancing (that is, polar) moieties on the polymer backbone greatly enhances the solubility of the polyarylene polymers as compared to conventional polyarylene polymers. Also, the relatively higher molecular weight (M_{w}) and relatively lower PDI (from 1 to <6) allow the formation of thicker polyarylene polymer coatings to be deposited in a single step with enhanced mechanical and electrical performance as compared to other polyarylene polymers having a solubility enhancing moiety, such as those disclosed in U.S. Pat. App. No. 15/056,352 (filed on February 29, 2016). Coating layers of the present polyarylene polymers show excellent film thickness retention. For example, coating layers having a deposited film thickness of ≥ 30 µm, such as films having a thickness of 30 to 125 µm, retain ≥ 80% of film thickness upon curing at 400 °C for 60 minutes. The present polymers have excellent thermal stability, showing a weight loss of only 0.5% or 1.5% when heated under inert atmosphere (e.g., N₂) at 400 or 450 °C, respectively, for one hour. Cured films of the present polymers have excellent flexibility. For example, a cured 30 µm thick film has a bending radius of at least 1 mm, and can be bent around such radius ≥ 5000 times without breaking or cracking. Cured films of the present polymers also have good optical transmittance, where, for example, a cured 10 µm thick film has a total transmittance of 88% and a haze of 0.15% as determined by ASTM D1003, and a yellowness index of 7.8 as determined by ASTM E313.

The polymers of the present invention are particularly useful in forming a relatively low dielectric constant insulating cured polyarylene material on an electronic device substrate, such as in integrated circuits, circuit packaging applications, multichip modules, circuit boards, flexible displays, and the like. Cured polyarylene dielectric material produced according to the present invention may be used as is or may be combined with one or more additional dielectric materials, which may be organic or inorganic, to provide the desired insulation layer. Accordingly, the polymers of the present invention may be used to deposit a coating on a variety of electronic device substrates, including, without limitation, FR-4, silica, silicon nitride, silicon oxynitride, silicon carbide, silicon-germanium, gallium-arsenide, indium-phosphide, aluminum nitride, alumina, and the like.

Example 1. A 4-L cylindrical reactor was charged with 485.010 g diphenylene oxide bis(triphenylcyclopentadienone) (DPO-CPD, 1.0 equivalents), 27.370 g (0.25 equivalents) of 3,5-diethynylbenzoic acid (DEBzOH), and 2422 g of GBL at room temperature. The top of the flask was then equipped with a dry ice condenser, a thermocouple with a temperature controller, N₂ inlets, and a stir system. The flask was placed into a fitted heating mantle. The system was evacuated and purged three times with N₂ to remove air from the reactor, which was subsequently blanketed with a constant flow of N₂. The reaction was then heated to an internal temperature of 135 °C. After 1 hour, the system was allowed to cool to 90 °C, followed by adding a second aliquot (27.780 g, 0.25 equivalents) of DEBzOH to the flask, along with an additional 300 g of GBL. The reaction mixture was again heated to 135 °C and kept at this temperature for 1 hour. The system was again allowed to cool to 90 °C, followed by adding a third aliquot (27.110 g, 0.25 equivalents) of DEBzOH to the flask, along with an additional 330 g GBL. The reaction mixture was again heated to 135 °C and kept at this temperature for 1 hour, after which time the system was again allowed to cool to 90 °C, followed by adding a fourth aliquot (30.763 g, 0.29 equivalents) of DEBzOH to the flask, along with an additional 330 g GBL. The reaction mixture was again heated to 135 °C and kept at this temperature for 6 hours, after which the reaction mixture was then cooled to room temperature. The resulting polymer (Polymer 1) was isolated from the reaction mixture by precipitating it from solution by adding isopropanol at room temperature, filtered, and washed with additional isopropanol before the filtrate was dried at 70 °C for 24 hours.

Before precipitation of Polymer 1, the reaction mixture was analyzed by GPC using an Agilent HPLC system equipped with a refractive index detector and using uninhibited tetrahydrofuran as eluting solvent at 1.2 mL/min; Temperature: 35 °C; Injection Volume: 150 µL; Polystyrene Narrow Standard calibration 483,000 to 162, Lower Mw cutoff = 160 Da; with the HPLC column setting as follows: Shodex-KF805, exclusion limit 4,000,000; Shodex-KF804, exclusion limit 400,000; Shodex-KF803, exclusion limit 70,000; and Shodex-KF802, exclusion limit 5,000. The GPC results indicated Polymer 1 had RT (retention time) = 23.700 min, a Mn of 23,787 Da, Mw of 81,630 Da, and a PDI of 3.4.

Example 2. The procedure of Example 1 was repeated except that 500.09 g of DPO-CPD was used and DEBzOH was added as follows: 28.053 g (0.25 equivalents) as the first aliquot; 28.023 g ((0.25 equivalents) as the second aliquot; 28.097 g (0.25 equivalents) as the third aliquot; and 32.39 g (0.29 equivalents) as the fourth aliquot. After the addition of the fourth aliquot, the mixture was allowed to react for 8.5 hours to provide Polymer 2. Analysis by GPC indicated Polymer 2 had a RT of 24.083 min, a Mₙ of 22,650 Da, M_{w} of 85,600 Da, and a PDI of 3.8.

Example 3. A reaction flask was charged with 20.13 g DPO-CPD, 3.31 g (0.75 equivalents) of DEBzOH, and 58 g of GBL at room temperature. The top of the flask was then equipped with a dry ice condenser, a thermocouple with a temperature controller, N₂ inlets, and a stir system. The flask was placed into a fitted heating mantle. The system was evacuated and purged three times with N₂ to remove air from the flask followed by a constant flow of N₂. The reaction was then heated to 135 °C. After 4 hours, the system was allowed to cool to 90 °C, followed by adding a second aliquot (1.27 g, 0.29 equivalents) of DEBzOH to the flask, along with an additional 10 g of GBL. The reaction mixture was again heated to 135 °C and kept at this temperature for 3 hours to provide Polymer 3. Analysis of the product by GPC indicated Polymer 3 had a RT of 24.233 min, a Mₙ of 21,300 Da, M_{w} of 52,400 Da, and a PDI of 2.46.

Example 4. The general procedure of Example 3 was repeated except that 60 g of DPO-CPD was charged to the reaction flask, along with 10.08 g (0.75 equivalents) of DEBzOH and 210 g of GBL and a different temperature profile, in which the mixture was first heated to 90 °C for 2 hours followed by heating at 115 °C for 2 hours then 135 °C for 4 hours. Next, the system was allowed to cool to 90 °C, followed by adding a second aliquot (3.92 g, 0.29 equivalents) of DEBzOH to the flask, along with an additional 70 g of GBL. The reaction mixture was again heated to 135 °C and kept at this temperature for 2 hours to provide Polymer 4. Analysis of the product by GPC indicated Polymer 4 had RT of 23.467 min, a Mₙ of 26,545 Da, M_{w} of 140,539 Da, and a PDI of 5.29.

Examples 5. The general procedure of Example 1 was repeated to provide Polymers 5 to 10, having the Mₙ, M_{w} and PDI reported in Table 1.

**Table 1**

| **Polymer** | **Mₙ** | **M_{w}** | **PDI** |
|---|---|---|---|
| 5 | 24,650 | 84,700 | 3.4 |
| 6 | 22,650 | 85,600 | 3.8 |
| 7 | 24,600 | 95,100 | 3.9 |
| 8 | 32,200 | 103,800 | 3.2 |
| 9 | 23,800 | 81,600 | 3.4 |
| 10 | 23,950 | 88,100 | 3.7 |

Example 6. The thermal stability of each of Polymers 5 and 6 from Example 5 was determined via thermogravimetric analysis on a TA Q5000 instrument using two different metrics. Degradation temperature, the temperature at which weight loss in the films is equal to 1% after an isothermal hold at 150 °C, was measured by ramping the temperature of the sample from room temperature to 150 °C at a rate of 10 °C/minute. Each sample was held at 150 °C for fifteen minutes, followed by heating once more at 10 °C/minute to 600 °C. Both Polymers 5 and 6 were found to have a degradation temperature of approximately 325 °C. Standard thermal stability, which was also measured by thermogravimetric analysis, is the weight loss during a one hour isothermal hold at a specified temperature, either 400 °C or 450 °C. Both Polymers 5 and 6 had good thermal stability, each having a weight loss of 0.5% at 400 °C and 1.5% at 450 °C.

Example 7. Films formed from Polymer 5 were evaluated to determine film thickness retention after cure. A solution of Polymer 5 (28 wt%) in a solvent blend of MMP/anisole/GBL (61.75/33.25/5 w/w/w) and containing 1 wt% of nonionic surfactants was spin coated on a silicon wafer at various spin speeds to form films of varying thicknesses. The thickness of each film was measured before and after curing at 400 °C for 60 min., and the change in thickness reported as a percentage of film thickness remaining in Table 2. Similarly, a solution of Polymer 5 (30 wt%) in a solvent blend of MMP/anisole/GBL (61.75/33.25/5 w/w/w) and containing 1 wt% of nonionic surfactants was coated on silicon wafers by bar coating using various spacer bar heights. The thickness of each film was measured before and after curing at 400 °C, and the change in thickness reported as a percentage of film thickness remaining in Table 3. Films having a thickness of > 100 µm were easily coated, however, such thick films required a stepwise curing profile.

**Table 2**

| **Spin Speed (rpm)** | **Pre-Cure Thickness (µm)** | **Post-Cure Thickness (µm)** | **Thickness Retention (%)** |
|---|---|---|---|
| 300 | 17.9 | 16.2 | 90.5 |
| 500 | 12.1 | 11.3 | 93.4 |
| 750 | 9.2 | 8.4 | 91.3 |
| 1000 | 7.9 | 7.2 | 91.1 |
| 1500 | 6.1 | 5.6 | 91.8 |
| 2000 | 5.5 | 4.8 | 87.3 |

**Table 3**

| **Spacer Bar Height (mm)** | **Pre-Cure Thickness (µm)** | **Post-Cure Thickness (µm)** | **Thickness Retention (%)** |
|---|---|---|---|
| 0.23 | 30 | 25 | 83.3 |
| 0.25 | 35 | 28 | 80.0 |
| 0.30 | 40 | 34 | 85.0 |
| 0.38 | 43 | 35 | 81.4 |
| 0.51 | 102 | Requires step-cure | - |
| 0.64 | 110 | Requires step-cure | - |

Example 8. The procedure of Example 7 was repeated except that Polymer 6 was used in place of Polymer 5. Films formed from Polymer 6 were found to have essentially the same film thickness retention.

Example 9. Thirty micron free-standing slot-die coated films formed from Polymer 6 were cut into strips and tested at The Pennsylvania State University using a flexible testing apparatus that was custom built in their labs. Each film was mounted on a KAPTON™ polyimide belt and repetitively bent around a mandrel with a 1 mm diameter, corresponding to approximately a 3% strain in the film. Several film strips were tested using the apparatus, and, on average, the films survived approximately 7,000 bending cycles before breaking. Even after breaking, confocal microscopy images of the films showed no cracks or tears induced by the bending.

Example 10. Young's Modulus and elongation of films formed from Polymer 5 were measured on an Instron 33R4464 using 10 µm thick free-standing films. The 25.4 mm by 9.9 mm films underwent tensile strain at a rate of 5 mm/minute. The calculated Young's Modulus for Polymer 5 from the stress-strain curve is 1.7 GPa. Such low modulus indicates that films of the present polymers have good flexibility, particularly as compared to conventional inorganic materials used in display applications. Much of the stress-strain curve follows an approximately linear relationship, indicating that elastic deformation occurs over the majority of the strained region, while comparatively less plastic deformation occurs. The curve of applied load versus extension shows that the films of Polymer 5 sustain approximately a 5% elongation before catastrophic mechanical failure occurs.

## Claims

1. A polyarylene polymer comprising as polymerized units one or more first monomers comprising two or more cyclopentadienone moieties; and one or more second monomers of formula (1): 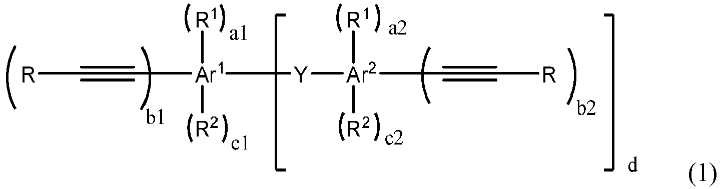 wherein each Ar¹ and Ar² is independently a C₅₋₃₀-aryl moiety; each R is independently chosen from H, and optionally substituted C₅₋₃₀-aryl; each R¹ is independently chosen from -OH, C₁₋₆-hydroxyalkyl, -C(=O)OR³, -C(=O)N(R⁴)₂, -O-C(=O)R,⁵-NR⁴C(=O)R⁶, -N(R⁴)₃⁺ An⁻, -NO₂; -S(=O)₂-OR⁷, -O-S(=O)₂-R⁸, -NR⁴-S(=O)₂-R⁶, and S(=O)₂-N(R⁴)₂; each R² is independently chosen from C₁₋₁₀-alkyl, C₁₋₁₀-haloalkyl, C₁₋₁₀-hydroxyalkyl, C₁₋₁₀-alkoxy, CN, N(R⁴)₂, and halo; R³ = H, C₁₋₁₀-alkyl, C₁₋₁₀-hydroxyalkyl, C₁₋₁₀-aminoalkyl, C₆₋₃₀-aryl, or M; each R⁴ is independently H, C₆₋₃₀-aryl, or C₁₋₁₀-alkyl; each R⁵ is independently chosen from H, C₁₋₁₀-alkyl, C₁₋₁₀-hydroxyalkyl, C₆₋₃₀-aryl, -O(C₁₋₁₀-alkyl), -O(C₆₋₁₀-aryl) and -N(R⁴)₂; R⁶ = H, C₁₋₁₀-alkyl, C₁₋₁₀-hydroxyalkyl, C₆₋₃₀-aryl, -O(C₁₋₁₀-alkyl), or -NH(C₁₋₁₀-alkyl); R⁷ = H, C₁₋₁₀-alkyl, C₆₋₃₀-aryl, or M; R⁸ = C₆₋₃₀-aryl, C₁₋₁₀-alkyl, or C₁₋₁₀-haloalkyl; M = an alkali metal ion, an alkaline earth metal ion, or an ammonium ion; An⁻ is an anion chosen from halide and C₁₋₂₀-carboxylate; each Y is independently a single covalent chemical bond or a divalent linking group chosen from -O-, -S-, -S(=O)-, -S(=O)₂-, -C(=O)-, - (C(R⁹)₂)_{z}-, C₆₋₃₀-aryl, and -(C(R⁹)₂)_{z1}-(C₆₋₃₀-aryl)-(C(R⁹)₂)_{z2}-; each R⁹ is independently chosen from H, hydroxy, halo, C₁₋₁₀-alkyl, C₁₋₁₀-haloalkyl, and C₆₋₃₀-aryl; a1 = 0 to 3; a2 = 0 to 3; b1 = 1 to 4; b2 = 0 to 2; c1 = 0 to 4; c2 = 0 to 4; a1 + a2 = 1 to 6; b1 + b2 = 2 to 6; c1 + c2 = 0 to 6; d = 0 to 2; z = 1 to 10; z1 = 0 to 10; z2 = 0 to 10; and z1 + z2 = 1 to 10; wherein the polyarylene polymer has a Mₙ of 10,000 to 50,000, a M_{w} of 30,000 to 150,000, and a PDI of 1 to <6.

2. The polyarylene polymer of claim 1 having a PDI of 1 to 4.5

3. The polyarylene polymer of claim 2 having a M_{w} of 50,000 to 150,000 Da.

4. The polyarylene polymer of claim 1 having a PDI of 1 to 4.

5. The polyarylene polymer of claim 1 having a M_{w} of 50,000 to 150,000 Da.

6. The polyarylene polymer of claim 1 wherein at least one first monomer has the formula
(9) 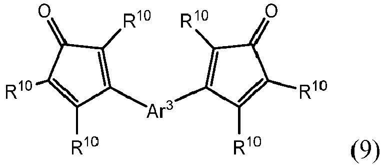 wherein each R¹⁰ is independently chosen from H, C₁₋₆-alkyl, or substituted or unsubstituted C₅₋₁₀-aryl; and Ar³ is an aromatic moiety having from 5 to 60 carbons.

7. The polyarylene polymer of claim 1 wherein R₁ is OH or C(=O)-OH.

8. The polyarylene polymer of claim 1 wherein at least one second monomer has the formula (4) 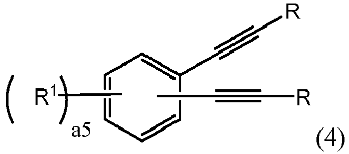 wherein each R is independently H or phenyl; each R¹ is OH or C(=O)-OH; and a5 = 1 or 2.

9. The polyarylene resin of claim 8 having a PDI of 1 to 4.5.

10. A composition comprising one or more polyarylene polymers of claim 1 and one or more organic solvents.

11. A composition comprising one or more polyarylene polymers of claim 9 and one or more organic solvents.

12. A method of forming a dielectric material layer comprising: disposing a layer of the composition of claim 1 on a substrate surface; removing the organic solvent; and curing the polymer to form a dielectric material layer.

13. A method of preparing a polyarylene polymer comprising: (a) reacting a molar amount of a first monomer comprising two or more cyclopentadienone moieties with a first portion of a molar amount of a second monomer formula (1): 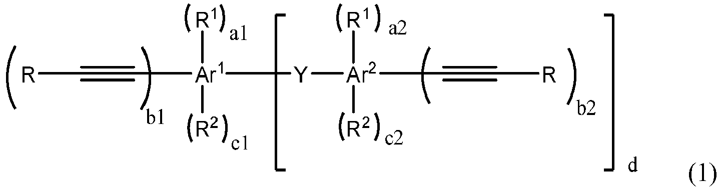 wherein each Ar¹ and Ar² is independently a C₅₋₃₀-arylmoiety; each R is independently chosen from H, and optionally substituted C₅₋₃₀-aryl; each R¹ is independently chosen from -OH, C₁₋₆-hydroxyalkyl, -C(=O)OR³, -C(=O)N(R⁴)₂, -O-C(=O)R,⁵-NR⁴C(=O)R⁶, -N(R⁴)₃⁺ An⁻, -NO₂; -S(=O)₂-OR⁷, -O-S(=O)₂-R⁸, -NR⁴-S(=O)₂-R⁶, and S(=O)₂-N(R⁴)₂; each R² is independently chosen from C₁₋₁₀-alkyl, C₁₋₁₀-haloalkyl, C₁₋₁₀-hydroxyalkyl, C₁₋₁₀-alkoxy, CN, N(R⁴)₂, and halo; R³ = H, C₁₋₁₀-alkyl, C₁₋₁₀-hydroxyalkyl, C₁₋₁₀-aminoalkyl, C₆₋₃₀-aryl, or M; each R⁴ is independently H, C₆₋₃₀-aryl, or C₁₋₁₀-alkyl; each R⁵ is independently chosen from H, C₁₋₁₀-alkyl, C₁₋₁₀-hydroxyalkyl, C₆₋₃₀-aryl, -O(C₁₋₁₀-alkyl), -O(C₆₋₁₀-aryl) and -N(R⁴)₂; R⁶ = H, C₁₋₁₀-alkyl, C₁₋₁₀-hydroxyalkyl, C₆₋₃₀-aryl, -O(C₁₋₁₀-alkyl), or -NH(C₁₋₁₀-alkyl); R⁷ = H, C₁₋₁₀-alkyl, C₆₋₃₀-aryl, or M; R⁸ = C₆₋₃₀-aryl, C₁₋₁₀-alkyl, or C₁₋₁₀-haloalkyl; M = an alkali metal ion, an alkaline earth metal ion, or an ammonium ion; An⁻ is an anion chosen from halide and C₁₋₂₀-carboxylate; each Y is independently a single covalent chemical bond or a divalent linking group chosen from -O-, -S-, -S(=O)-, -S(=O)₂-, -C(=O)-,-(C(R⁹)₂)_{z}-, C₆₋₃₀-aryl, and -(C(R⁹)₂)_{z1}-(C₆₋₃₀-aryl)-(C(R⁹)₂)_{z2}-; each R⁹ is independently chosen from H, hydroxy, halo, C₁₋₁₀-alkyl, C₁₋₁₀-haloalkyl, and C₆₋₃₀-aryl; a1 = 0 to 3; a2 = 0 to 3; b1 = 1 to 4; b2 = 0 to 2; c1 = 0 to 4; c2 = 0 to 4; a1 + a2 = 1 to 6; b1 + b2 = 2 to 6; c1 + c2 = 0 to 6; d = 0 to 2; z = 1 to 10; z1 = 0 to 10; z2 = 0 to 10; and z1 + z2 = 1 to 10; then (b) reacting the molar amount of the first monomer with a second portion of the second monomer; and (c) optionally repeating step (b) with one or more additional portions of the second monomer; wherein the first portion of the second monomer is less than 1 equivalent based on the molar amount of the first monomer; wherein the sum of the first portion, the second portion and any optional addition portions of the second monomer is from 0.8 to 1.2 molar equivalents based on the molar amount of the first monomer; and wherein the polyarylene polymer has a Mₙ of 10,000 to 50,000, a M_{w} of 30,000 to 150,000, and a PDI of 1 to <6.
